# EUROPEAN PATENT APPLICATION

(11) **EP 4 174 219 A1**
(43) Date of publication of application: **03.05.2023**
(21) Application number: 21306536.0
(22) Date of filing: 02.11.2021
(51) Int. Cl.: C25D 11/02, C25D 11/18, H01L 49/02, C25D 11/04, H01G 11/26

(54) **NANOWIRE ARRAY STRUCTURES FOR INTEGRATION, PRODUCTS INCORPORATING THE STRUCTURES, AND METHODS OF MANUFACTURE THEREOF**

(71) Applicant: Murata Manufacturing Co., Ltd., Nagaokakyo-shi, Kyoto 617-8555 (JP); Commissariat à l'Énergie Atomique et aux Énergies Alternatives, 75015 Paris (FR)
(72) Inventor: EL SABAHY, Julien, 38100 GRENOBLE (FR); VOIRON, Frédéric, 38530 BARRAUX (FR); GABETTE, Laurence, 38054 GRENOBLE Cedex 09 (FR)
(74) Representative: Cabinet Beau de Loménie

(57) **Abstract**

A nanowire array structure and its method of fabrication are disclosed. The structure (100) has an array of nanopillars (138) located in a well (160) in a material layer (128). The nanopillars of the array extend in the direction from the well floor (164) towards the well mouth (168). A hard mask (140) overlies the outer peripheral nanopillars in the array and extends outwards to cover the remainder of the well mouth. An aperture (142) in the hard mask (140) exposes the nanopillars disposed inwardly of the outer peripheral nanopillars. The hard mask (140) planarizes the structure, avoiding formation of large topological features at the periphery of the array of nanopillars, thus facilitating integration of the structure into a semiconductor product. At least some of the outer peripheral nanopillars may be in pores of anodic oxide. There are also disclosed semiconductor products incorporating such nanowire array structures and methods of their fabrication.

## Description

### Field of the Invention

The present invention relates to the field of integration and, more particularly, to nanowire structures for integration, electronic products and related semiconductor products including such nanowire structures, and their methods of manufacture.

### Technical Background

Nowadays, semiconductor manufacturing techniques include technologies for integrating passive components. For example, the PICS technology developed by Murata Integrated Passive Solutions allows high density capacitive components to be integrated into a silicon substrate. According to this technology, tens or even hundreds of passive components can be efficiently integrated into a silicon die.

In their work titled "Nanotubular metal-insulator-metal capacitor arrays for energy storage" (published in Natural technology, May 2009), P. Banerjee *et al.* describe a metal-insulator-metal (MIM) structure formed in a porous anodic material, such as porous anodic alumina (PAA) for example. The successive layers of metal, insulator, and then metal follow the contours of the porous material resulting in the MIM structure being embedded inside the pores of the porous material and, thus, increase the specific area of the capacitor electrodes. Banerjee's PAA embedded structure however suffers from high Equivalent Series Resistance (ESR) and limited capacitance density due to the PAA thickness that can be deposited by Atomic Layer Deposition (ALD).

Generally, embedded structures as described above result from embedding a structure (e.g., a MIM capacitive stack) inside a porous region above a substrate, such as a silicon wafer. Typically, the porous region results from anodizing a thin layer of metal, such as aluminium, deposited above the substrate. The anodization process converts the metal layer into a porous anodic oxide (e.g. an aluminium layer is converted into porous anodic alumina). The anodization process may be implemented in a known manner to form a self-organized array of elongated pores that are substantially parallel to one another and substantially perpendicular to the substrate surface, at least in the central zone of the porous region. Typically, the boundary of the porous region may be formed with any desired shape (as viewed from the top) by use of a suitable hard mask.

A structure by F. Voiron *et al.* that improves Banerjee's ESR and capacitance is described in international application publication WO 2015/063420. Voiron's structure results in highly integrated capacitance that may be used in a variety of applications. In this structure the bottoms of the pores are opened and the lower metal layer of the MIM structure contacts a conductive layer that underlies the porous region, providing electrical contact and reducing ESR.

This latter technology provides highly-integrated capacitance which can be used for different applications. For some applications, Equivalent Series Resistance (ESR) is a key parameter of the device. This is for example the case for capacitive elements used for decoupling processors. In this context, capacitors are used as a local energy tank (and thus are placed very nearby to the processor), to compensate for voltage drop induced by power supply line impedance in the case of large current swings.

Those current swings can be as large as 100A for recent processors. In that case, the capacitor can provide the charges (i.e. current) required by the processor for a short period. As the current provided by the capacitor is fed through the internal capacitor resistance (Equivalent Series Resistance), it is desirable that the ESR is kept as low as possible to prevent voltage drop at the capacitor terminal. Similar reasoning applies for the inductive parasitics (i.e. Equivalent Series Inductance) that also should be minimized. Finally, the larger the capacitance (i.e. specific capacitance density) the larger the event that can be filtered by the capacitor: for example, a supply interruption lasting about a picosecond for a capacitor having capacitance of approximately 1nF, and a nanosecond supply interruption for a µF capacitor.

As described in the Applicants' earlier patent application EP 3656734, an even lower ESR can be achieved, together with 15% increase in capacitance density, by using a different approach for increasing the specific area of the capacitor electrodes, namely forming the MIM capacitive stack conformally over a group of aligned nanopillars projecting from the substrate (instead of embedding the MIM stack in pores of porous anodic oxide).

In the case described in EP 3656734 the nanopillars are metallic nanowires and they are formed by first creating a porous anodic oxide matrix, then forming metallic columns within the pores, then removing the porous anodic oxide matrix to release the nanowires.

Other techniques are known for forming aligned arrays of nanopillars projecting from a substrate. For example, WO 2008/060665 describes techniques for forming an array of aligned carbon nanotubes by chemical vapour deposition (CVD) using a patterned catalyst.

It should be noted that other electronic structures, besides capacitive structures, can be formed using such arrays of aligned nanopillars.

Despites the advantages that derive from using arrays of aligned nanopillars to form electronic components for integration into integrated circuits, the vertical extension of the wires above the substrate surface intrinsically generates relief features (high topologies) that can be difficult to manage. More particularly, integrated circuit manufacture generally involves formation of various active and/or passive components in a plurality of superposed layers. In the case where significant relief features are produced in a particular layer of the circuit, it may be difficult (or, even, impossible) to form the layer(s) that should be superposed on that particular layer and/or difficult to create contacts to the components formed in that particular layer.

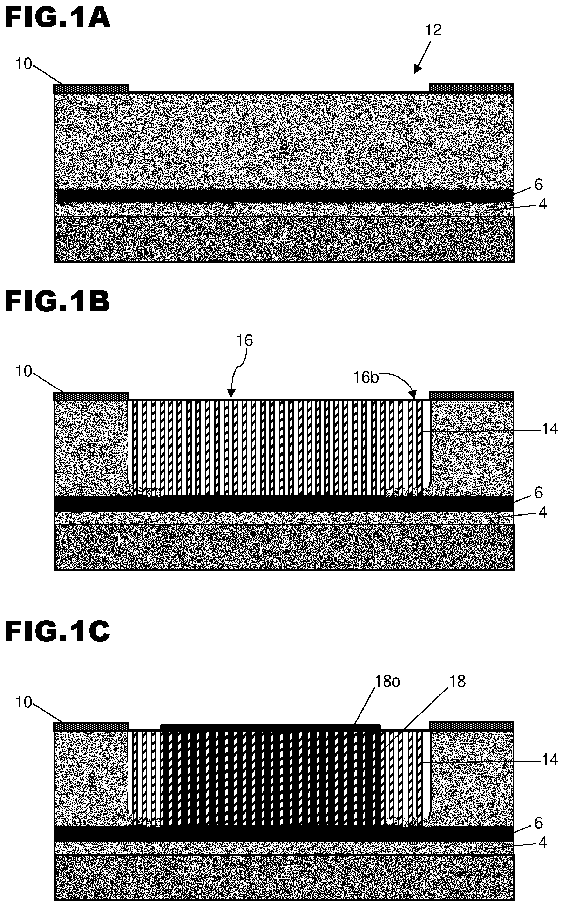

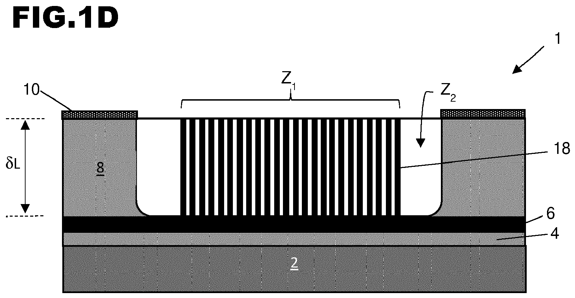

This problem will be discussed in greater depth with reference to FIG.1. FIG.1 illustrates the problem in the context of a nanowire structure formed by creating metallic nanowires in pores of an AAO template that is partially etched such as to leave free wires, anchored on a substrate surface, into a well surrounded by an AAO porous medium. However, this is solely an example of implementation, and it is to be understood that comparable problems arise in the case of nanopillar arrays formed by other processes in a three-dimensional well (e.g., nanopillar arrays formed by the CVD + patterned catalyst process of WO 2008/060665).

FIG. 1 illustrates the stages in a process of the related art for forming a nanowire array structure on a semiconductor substrate in view of forming a MIM capacitive stack over the nanowires.

In this example, as illustrated in FIG.1A, upon a semiconductor substrate 2 a conductive layer 4 is formed to enable electrical contact to be made, subsequently, with the lower metal layer of the MIM stack (to reduce ESR as in Voiron's structure described above). In this example the conductive layer 4 is made of aluminium. A barrier layer 6 is then formed on the conductive layer 4 to provide protection to conductive layer 4, e.g., by stopping the progression of a subsequent anodization process from reaching conductive layer 4 and/or providing protection during a subsequent PAA etching step of the fabrication process.. In this example, the barrier layer 6 is made of tungsten or titanium and has sufficient electrical conductivity to allow contact to the conductive layer 4. A metal layer 8 for anodization is then formed on the anodization-stop layer 6. In this example the metal layer for anodization is made of aluminium and a subsequent anodization process is intended to form a porous region within this layer 8.

It may be desirable for some applications to form a circumscribed porous region within the original metal layer 8. For example, it may be desirable to control the size of the resulting porous region in order to control the size and electrical value (e.g., capacitance, resistance, etc.) of the electronic component that will be formed there. Typically, this is done by applying, on top of metal layer 8, a hard mask layer 10 with openings 12 therein to define regions where porous AAO is to be formed. Hard mask layer 10 masks the part of metal layer 8 that is not intended to be anodized. The masking shields this area from contact with the anodization electrolyte, and the porous region is thus formed in the area(s) of metal layer 8 where hard mask layer 10 is open.

Typically, a silicon dioxide masking layer is used for the hard mask 10. This choice is driven by several factors, including the availability of a silicon dioxide deposition process at medium/low temperature that is compatible with deposition above an aluminium-based stack, the availability of silicon dioxide patterning techniques with good selectivity on an underlying aluminium layer, the resistance of silicon dioxide to the anodization step, and the relatively low stress induced by an oxide layer.

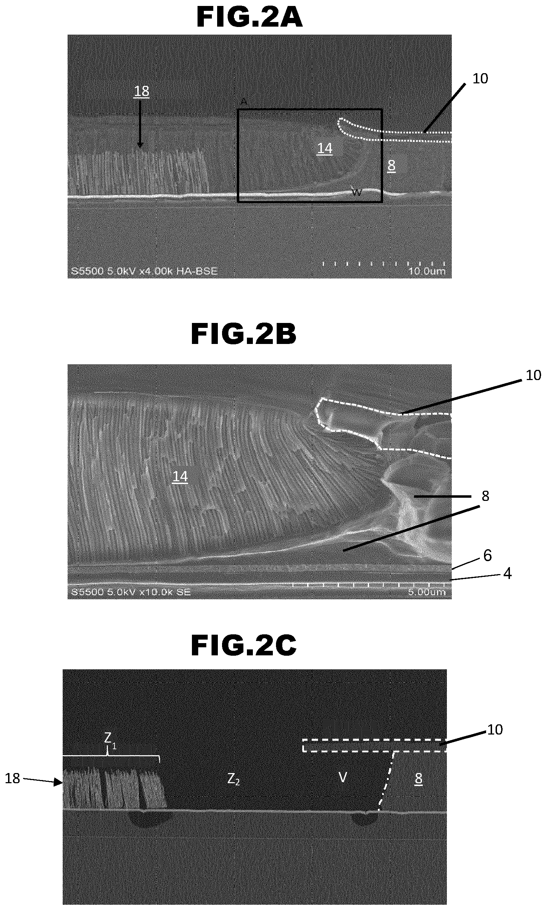

However, while this choice is beneficial for the reasons mentioned above, it has an undesirable effect on pore formation in the region of the metal layer 8 adjacent to the hard mask. In effect, the use of silicon dioxide for the hard mask layer 10 weakens the anodization electrical field through the underlying metal layer 8 in the vicinity of the hard mask edge. This weakening of the anodization electrical field results in pores being not fully open and/or malformed at the periphery of the porous region. This issue is discussed below with reference to Figs. 2A to 2C which are scanning electron microscope images of the periphery of the porous region formed by anodization using a silicon dioxide hard mask over a metal layer 8 made of aluminium.

Using known process steps and process conditions, regions in the metal layer 8 are anodized, converting aluminium in these regions to porous AAO 14 containing pores 16 extending all the way down to the anodization-stop layer 6, the pores being in a self-organized array, as illustrated in FIG.1B. In fact, as illustrated schematically in FIG.1B, and in the scanning electron micrographs of FIGs.2A and 2B, at the periphery of the porous regions there are pores 16b in the AAO 14 which do not extend all the way down to the anodization-stop layer 6. Instead, some of the original metal of layer 8 remains underneath these pores 16b. Furthermore, at the periphery of the porous regions the pores are not oriented substantially perpendicularly to the substrate but, instead, are significantly tilted. Also, at the periphery of the porous regions, because the porous AAO occupies a greater volume than the original aluminium metal of layer 8, the edges of the mask 10 are pushed upwards (as can be seen in Figs.2A and 2B).

The desired array of nanowires 18 is created by depositing metal into the pores 16 of the porous AAO matrix 14, as illustrated by FIG.1C. This can be achieved, for example, by electrodeposition of a metallic species. In the illustrated example, the metal is deposited so as to overflow the tops of the pores, capping the nanowire structure and forming an overflow portion 18o, but this is optional. The nanowires 18 are then released by removing the porous AAO template 14 (e.g. by a selective etching process), to leave an array of nanowires as illustrated in FIG.1D. This type of regular nanopillar structure can be used to embed capacitive structures, or other electronic components.

The removal of the porous AAO template 14 used to form the nanowires gives rise to significant topology (relief features), because a cavity is formed around the periphery of the nanowire structure. Considering FIG.1D, it can be seen that there is a significant height difference δL between the top of the set of nanowires present in a zone Z₁, and the surface of the anodization-stop layer 6 exposed at the periphery of the nanowire structure in a zone Z₂.

Furthermore, an over-etching may occur below the hard mask 10 that is used to delimit the region where the porous AAO region 14 is formed, creating a void V under the edge part of the hard mask 10 as can be seen in FIG. 2C. The cavity region Z₂ may extend laterally over a distance on the order of 30µm and over-etching below the hard mask 10 may create a void V extending laterally over a distance of 10 µm. The lateral extent of the cavity region Z₂ and the lateral extent of the void V both increase for nanopillars that have greater height, and for capped nanopillar structures, because in such cases longer etching time is needed to release the wires.

The nanopillar structure may be produced with a view to integrating an electronic component into an integrated circuit. In such a case, the presence of the cavity in region Z₂ is detrimental to the subsequent step of the manufacturing process, because it may prevent the next photolithographic step (even coating with photo-resist may become impossible). Also it is detrimental to continuity of superposed layers: i.e., it may result in discontinuity of metallic or insulating layers that are used superposed over the nanowire structure and which are used for forming the interconnections to the electronic component embedded using the nanowire structure. Accordingly, up to now it has been difficult to integrate, into integrated circuits or semiconductor products, electronic components that are embedded over an array of nanowires.

The present invention has been made in the light of the above problems.

### Summary of the Invention

The present invention provides a nanopillar array structure, a semiconductor product, a method of fabricating the nanowire array structure and a method of fabricating the semiconductor product which employ a level-sustaining hard mask to avoid formation of significant topological features that would hinder integration of a nanopillar array.

More particularly, the present invention provides a nanopillar array structure, comprising:
a material layer comprising a well: the well having a sidewall, a well floor and a well mouth facing said well floor;
an array of nanopillars located in said well and extending in the direction from the well floor towards the well mouth; and
a hard mask overlying the outer peripheral nanopillars in said array and extending outwards to cover the remainder of the well mouth;
wherein an aperture in said hard mask exposes the nanopillars disposed inwardly of said outer peripheral nanopillars.

In the nanowire array structure according to the present invention, the hard mask closes off the well mouth around the periphery of the array of nanopillars, so that only small topological features remain and the nanowire array structure is well-adapted for integration into an integrated circuit or electronic component. The hard mask may be considered to sustain the level of the topography.

The above-mentioned nanopillar array structure may comprise porous anodic oxide material at the periphery of the array of nanopillars and the nanopillars may be conductive nanowires. In such a case, the outer peripheral nanopillars may comprise peripheral nanowires disposed in pores of the porous anodic oxide material and the hard mask may overlie said peripheral nanowires disposed in the pores of the porous anodic oxide material. In some cases the porous anodic oxide material at the periphery of the array of nanopillars may comprise a first region, R₂, where the pores contain nanowires and a second region, R₃, outward of the first region and closer to the well sidewall, where the pores do not contain nanowires. The level-sustaining hard mask may overlie both of these regions of the porous anodic oxide material.

In the case where the level-sustaining hard mask overlies nanowires located in pores of a porous anodic oxide material there is increased support for the hard mask at the edge of the aperture(s) therein, reducing strain and reducing the risk of cracking.

The level-sustaining hard mask may be removed from the latter configuration, producing a nanowire array structure in which an array of released nanowires is surrounded by a first region containing porous anodic oxide with nanowires in the pores and the first region is surrounded by a second region consisting of porous anodic oxide having pores that do not contain nanowires.

In the above-mentioned nanopillar array structures the material layer may overlie a conductive layer and a surface of the conductive layer may (wholly or partially) define the well floor, and at least some of the nanopillars disposed inwardly of the outer peripheral nanopillars make contact with the conductive layer at the well floor. In this configuration, in the case where the nanopillars are made of electrically conductive material, electrical contact to the nanopillars may be made at the bottom of the well. This may allow an electronic component implemented using the nanopillar arrays structure to be connected to another component in an integrated circuit, resulting in a functional module.

The present invention further provides a semiconductor product comprising a nanopillar array structure as described above, and an electronic component constituted by one or more layers embedded in the array of nanopillars. The electronic component may be a capacitive component constituted, for example, by a metal-insulator-metal (MIM) stack embedded in the nanopillar array structure.

In the case where an electronic component is implemented by embedding layers in a nanopillar array of such a nanopillar array structure, the surface area of the layers embedded over the nanopillars is large and so high values of properties, such as capacitance, can be attained.

The above-mentioned semiconductor products may further comprise an interconnect structure comprising a plurality of nanowires located in respective pores of a region of porous anodic oxide material. Such an interconnect structure may extend from the back side of the product to the front side and may allow electrical contact to be made to two terminals at the same side of the semiconductor product. Advantageously, in the case where the electronic component layers are embedded in an array of nanowires, common process steps may be used to make the nanowires in the interconnect structure and the nanowires of the array, reducing the overall number of steps in the method of fabrication.

The present invention yet further provides a method of fabricating a nanopillar array structure, comprising:
forming an array of nanopillars located in a well comprised in a material layer, the well having a sidewall, a well floor and a well mouth facing said well floor, the nanowires of said array extending in the direction from the well floor towards the well mouth; and
forming a hard mask overlying the outer peripheral nanopillars in said array and extending outwards to cover the remainder of the well mouth, wherein an aperture in said hard mask exposes the nanopillars disposed inwardly of said outer peripheral nanopillars.

By forming the mask covering the well mouth region peripheral to the centre of the nanopillar array, the method according to the invention prevents formation at the periphery of the array of large topographical features (large steps/height differences) which, otherwise, would arise and would hinder integration of the nanopillar array structure in a semiconductor product.

In the method of fabricating the nanopillar array structure:
the forming of the array of nanopillars may comprise forming an array of nanowires in pores of a porous anodic oxide material;
the forming of the hard mask may comprise forming a hard mask overlying the outer peripheral nanowires in the array and extending outwards to cover the remainder of the well mouth, wherein an aperture in the hard mask exposes the nanowires disposed inwardly of said outer peripheral nanowires; and
after the forming of the hard mask, there may be a step of releasing the exposed nanowires (i.e. those disposed inwardly of said outer peripheral nanowires), by selectively removing the porous anodic oxide material from between the exposed nanowires, leaving under the hard mask some nanowires located in pores of the porous anodic oxide material.

By leaving under the hard mask some porous anodic oxide material whose pores contain nanowire material, the latter method assures better support for the hard mask, reducing the risk of breakage thereof.

The present invention still further provides a method of fabricating a semiconductor product comprising: fabrication of a nanopillar array structure by a method as described above; and embedding, in the array of nanopillars, one or more layers to form an electronic component. In this method, the embedding of one or more layers in the array of nanopillars may comprise forming a metal-insulator-metal (MIM) stack over the array of nanopillars to form a capacitive component. According to such a method the surface area of layers in the electronic component is large and the values of electrical properties, such as capacitance, can be increased.

### Brief Description of the Drawings

Further features and advantages of the present invention will become apparent from the following description of certain embodiments thereof, given by way of illustration only, not limitation, with reference to the accompanying drawings in which:
FIGS. 1A-1D are schematic representations of cross-sectional views at different stages during fabrication of a nanowire structure by a method of the related art;
FIGS. 2A-2C are scanning electron microscopy (SEM) images illustrating the periphery of a region of porous anodic oxide produced by the method according to the related art, wherein:
   FIG.2A shows porous anodic oxide containing an array of nanowires,
   FIG.2B is a magnified view of a region enclosed by a rectangle in FIG.2A, and
   FIG.2C shows the region represented in FIG.2A after removal of the porous anodic oxide;

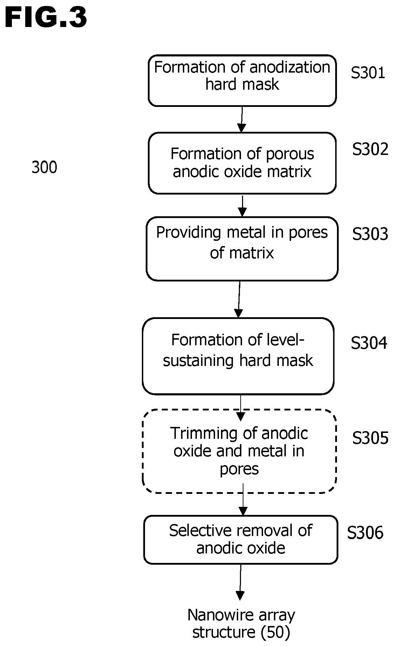

FIG. 3 is a flow diagram illustrating an example of a method of fabricating a nanowire array structure according to an embodiment of the present invention;

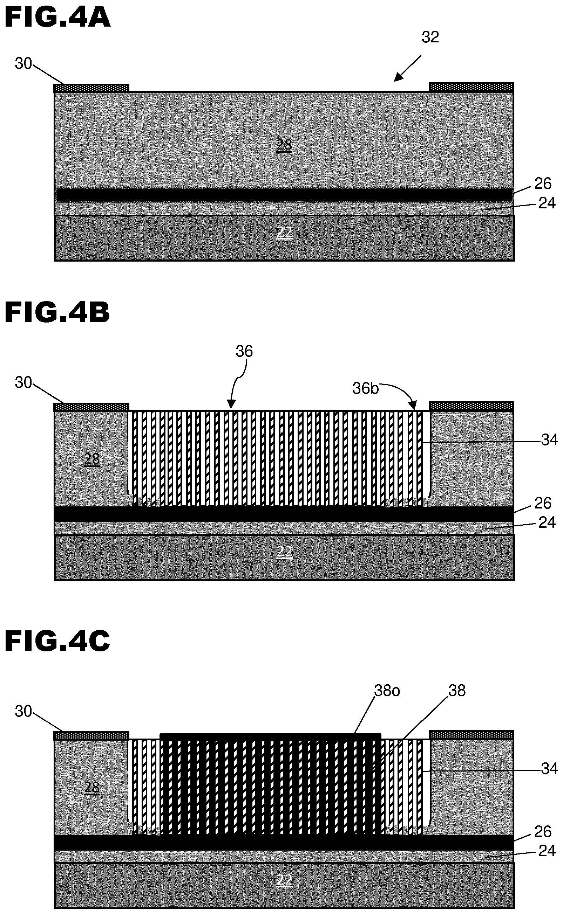

FIGs. 4A-4F are schematic representations of cross-sectional views at different stages during fabrication of a nanowire array structure by the method of FIG.3;

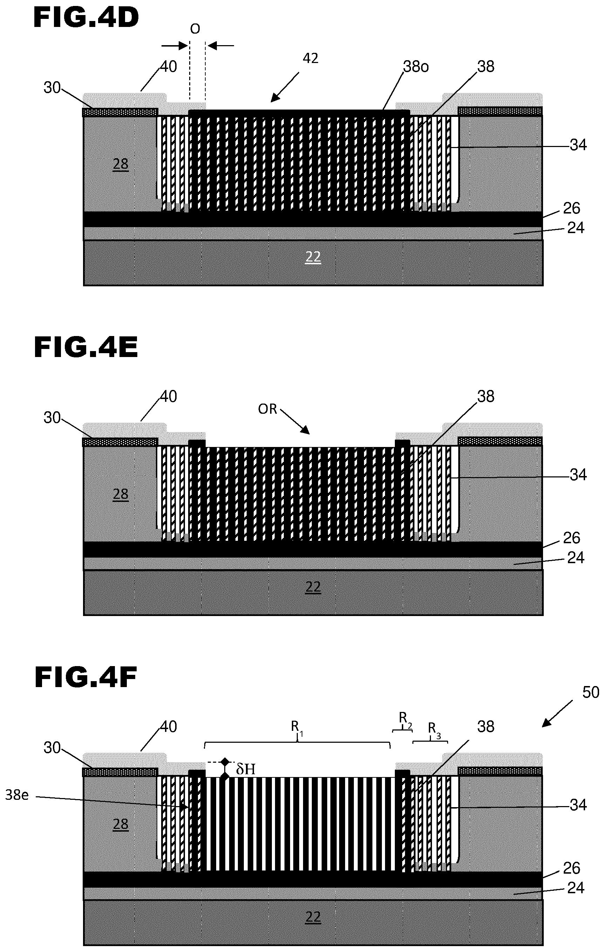

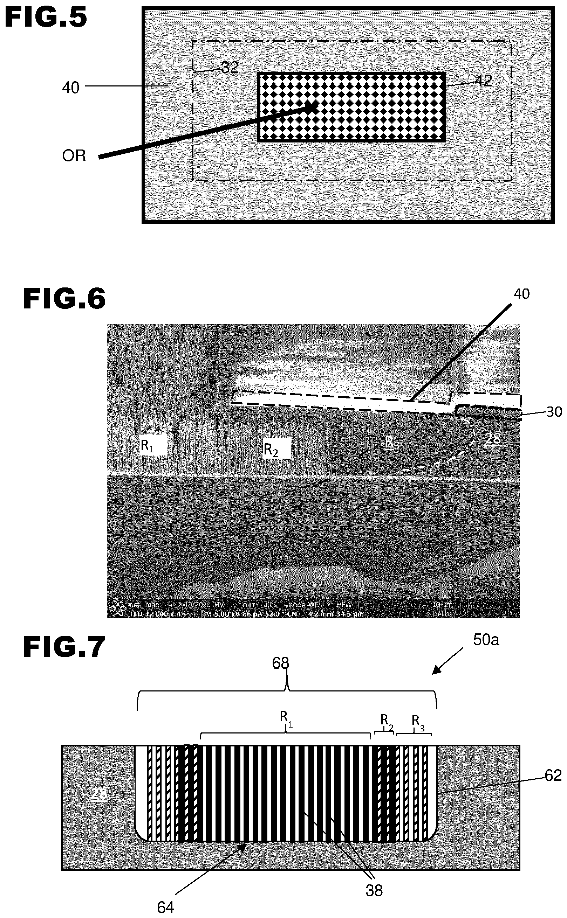

FIG. 5 is a schematic representation of a top view corresponding to the structure illustrated in FIG.4E;
FIG. 6 is an SEM image showing part of a nanowire array structure corresponding to FIG.4F;
FIG.7 is a schematic representation of a cross-section through a nanowire array structure from which a level-sustaining hard mask has been removed;

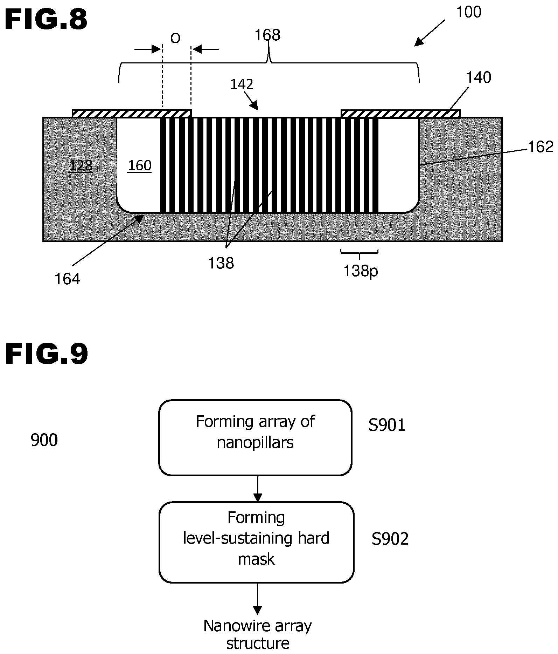

FIG.8 is a simplified representation of a cross-section through a generic nanopillar array structure according to an embodiment of the invention;
FIG.9 is a flow diagram illustrating a generic method of fabricating a nanopillar array structure according to an embodiment of the invention;

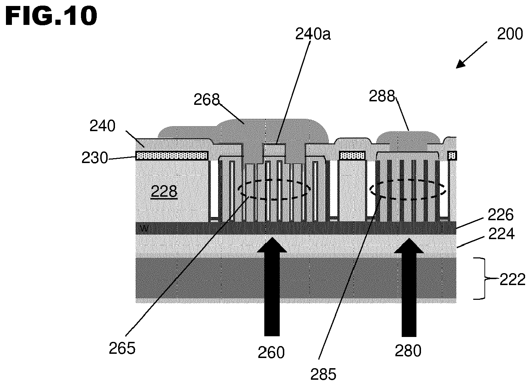

FIG.10 is a schematic view of a cross-section through a semiconductor product in which a capacitor has been formed over a nanowire array structure according to an embodiment of the present invention;

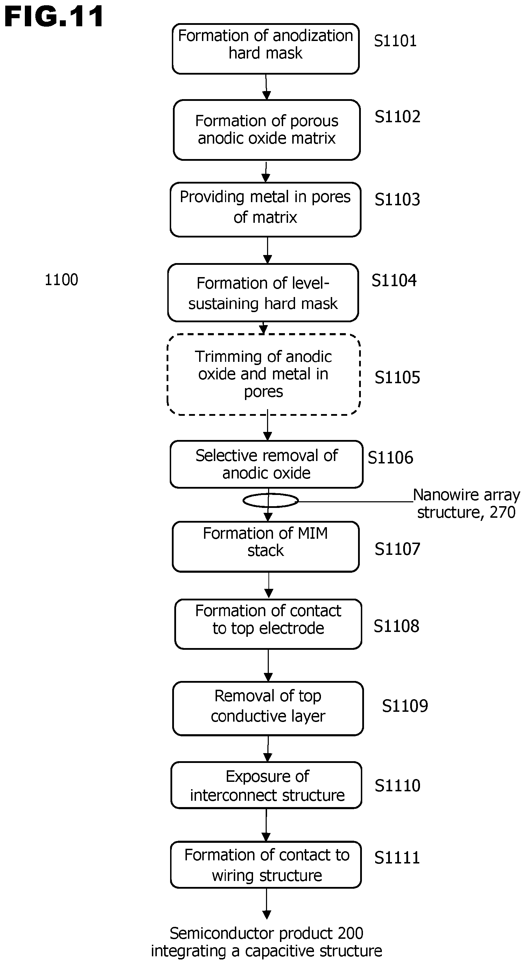

FIG.11 is a flow diagram illustrating an example of a method of fabricating a semiconductor product according to FIG.10;

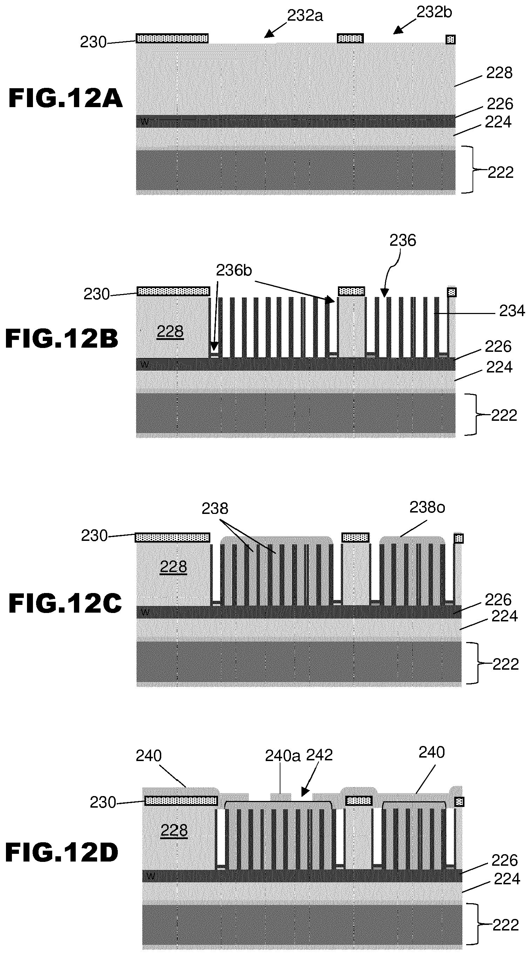

FIGs. 12A-12L are schematic representations of cross-sectional views at different stages during fabrication of a semiconductor product by the method of FIG.11;

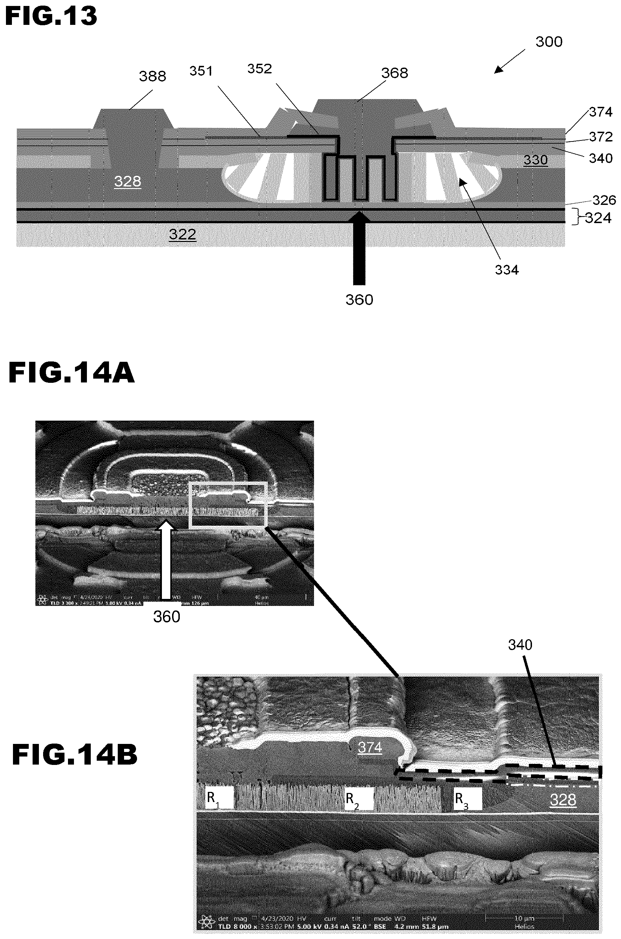

FIG. 13 is a cross-section through another example of a semiconductor product produced by a method according to the present invention;
FIGs.14A and 14B are SEM images of part of the semiconductor product of FIG.13, in which:
   FIG.14A is an image of a capacitive structure in the semiconductor product of FIG.13, and
   FIG.14B is a magnified view of part of FIG.14A; and

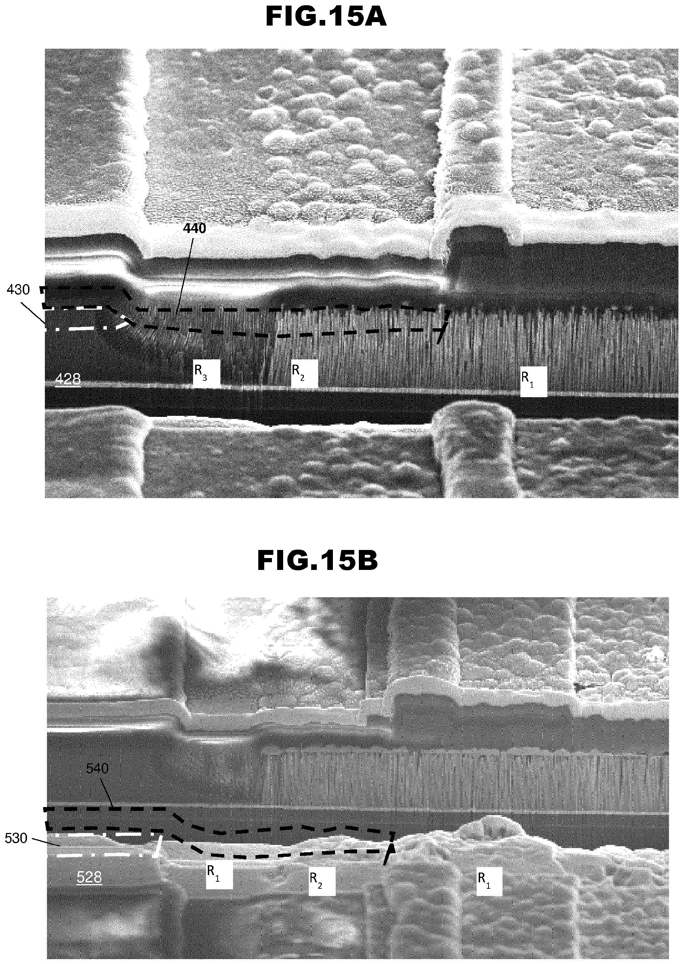

FIGs.15A and 15B are SEM images of additional nanowire array structures made by methods according to the invention, in which:
   FIG.15A shows a structure without overflowed nanowire material, and
   FIG.14B shows a structure having overflowed nanowire material.

### Detailed Description of Example Embodiments

Embodiments of the present invention address the existing deficiencies of the prior art by using a "level-sustaining" hard mask to prevent the formation, at the periphery of a nanopillar array, of cavities which cause topological features that might otherwise inhibit subsequent process steps when integrating the nanopillar array structure into a semiconductor product or integrated circuit.

In accordance with this feature, a method 300 of fabricating a nanopillar array structure according to an embodiment of the present invention will now be described with reference to the flow diagram of FIG.3 and with reference to Figs. 4A to 4F which show the structure at various stages in the fabrication process. As described further below, such a nanopillar array structure may be used to fabricate an electronic component including, but not limited to, a high-density integrated capacitor structure.

The example described below with reference to FIG.3 and FIGS.4A-4F details the implementation of an embodiment of the invention for the case of metallic nanowires formed in an AAO structure that is partially etched such as to leave free wires, anchored on a substrate surface, located in a well surrounded by an AAO porous medium. However, this is solely an example of implementation, and the planarization concept may be generalized to other types of nanowires (carbon nanotubes, etc.) that would be formed in a 3D well.

As in the method described above in connection with Figs.1A to 1C and FIGs.2A-2C, in the method 300 according to the present embodiment, an anodization hard mask 30 is formed (S301) on a laminated structure comprising a substrate 22, a conductive layer 24 formed on the substrate 22, a barrier layer 26, and a layer 28 of metal for anodization, as can be seen in FIG.4A. Openings 32 in the anodization hard mask 30 define regions where a porous anodic oxide template is to be formed.

The substrate 22 may be made, without limitation, of silicon, glass, or a polymer, and may be a raw (i.e., unprocessed) substrate or it may already be processed to a certain extent such that other electronic components are already formed thereon.

Conductive layer 24 is included in the structure in view of providing electrical contact at the bottom of the structure (as in Voiron's structure described in WO 2015/063420) and may be omitted if electrical contact is not needed underneath the nanowire array. Conductive layer 24 may include one or more metal layers including aluminium (Al), copper (Cu), silver (Ag), or aluminium copper (AlCu) combined or not with barrier metals such as titanium (Ti), titanium nitride (TiN), tantalum (Ta), and tantalum nitride (TaN). In one implementation, the conductive layer 24 is formed of an AlCu layer sandwiched between two TiN or TiTiN layers.

Barrier layer 26 is optional and serves to protect the conductive layer 24 (when present) during subsequent formation of the porous region. The barrier layer 26 has sufficient electrical conductivity to allow conduction between the conductive layer 24 and conductive material provided (subsequently) in pores of porous anodic oxide. The barrier layer 26 may be selected to act as an anodization stop layer for stopping the progression of anodization from reaching the conductive layer 24. In an embodiment, during the anodization, the barrier layer 26 may oxidize to form oxide plugs (not shown) at the bottom of the pores reaching the conductive layer 24. The oxide plugs may be etched away during a subsequent process step to allow electrical contact between the structure deposited into the pores and the conductive layer 24.

In another embodiment, the barrier layer 26 may also be selected so that it performs the function of shielding the conductive layer 24 from exposure to a halogen-based precursor that may be used in a subsequent process step. As such, the barrier layer 26 may be made of a metal that is resistant to halogen corrosion, such as W or Ti, for example.

The metal layer 28 may be made of an anodizable metal, such as aluminium for example.

Typically, a silicon dioxide masking layer is used for the anodization hard mask 30, but the invention is not limited to use of this material for the anodization hard mask. Other materials that may be used for the hard mask include, without limitation, silicon nitride, composite materials combining silicon oxide or nitride with a polymer, or a combination of any of those materials with a metallic barrier layer (e.g. made of tungsten). It is preferable to keep the thickness of the hard mask relatively low, so as to avoid formation of topological features but, generally, a minimum thickness is required (whose value depends on the anodization voltage). Typically, the thickness of the hard mask ranges from 0.5 to 1.5µm.

Using known process steps and process conditions, regions in the metal layer 28 that are exposed from the anodization hard mask 30 are anodized (S302), converting metal of the metal layer 18 in these regions to porous anodic metal oxide 34 containing a self-organized array of pores 36 extending all the way down to the barrier layer 26, as illustrated in FIG.4B. In the case where the metal layer 28 is made of aluminium, the porous anodic oxide matrix 34 is made of PAA. As in the method discussed above with reference to FIG.1B, at the periphery of the porous regions there are pores 36b which do not extend all the way down to the barrier layer 26; instead, some of the original metal of layer 28 remains underneath these pores. The porous anodic oxide matrix 34 will serve as a template for subsequent formation of an array of nanowires.

As part of this step S302, the bottom-ends of the pores 36 are opened (for example by using a selective etching process) to expose the metal that is underneath the pores. If desired, the anodization hard mask 30 may be selectively removed after this operation. In this embodiment of the invention, the pore bottom ends are opened in view of an intended application of the nanowire array structure for the formation of a high-density capacitive component having bottom contact as in WO 2015/063420. However, in other applications it may be appropriate to keep the pore bottoms closed and, if desired, the metal layer for anodization 28 may be formed on the substrate 22, omitting layers 24 and 26.

The porous matrix is made of an anodic oxide having a plurality of pores that extend from a top surface of the porous region toward the substrate 22. As used herein, the term "anodic oxide" is a generic term referring to a material including anodic oxide or hydroxide, and possibly carbon and hydrogen byproducts resulting from the anodization. Typically, the pores in the central part of the porous material extend perpendicularly or substantially perpendicularly to the substrate 22. Pores at the periphery of the porous region may have uneven depths and/or diameters.

An array of nanowires 38 is created by providing metal (S303) into the pores 36 of the porous anodic oxide matrix 34, as illustrated in FIG.4C. This can be achieved, for example, by electrodeposition of a metallic species. The porous anodic oxide template can be partially or completely filled with metal. In the illustrated example, the metal is deposited so as to overflow the tops of the pores, capping the nanowire structure and forming an overflow portion 38o, but this is optional.

A second hard mask 40 is formed (S304) over the anodization hard mask 30 (if the anodization hard mask 30 remains) and extends over an outer part of the region where the pores 36 contain metal, as shown in FIG.4D. Openings 32 in the second hard mask 40 define regions where the nanowires will be released in a subsequent step. The second hard mask 40 may be considered to be a "level-sustaining" hard mask insofar as it helps to prevent formation of large topological relief features that would otherwise hinder the integration, into a semiconductor product or integrated circuit, of the nanowire array structure that is to be formed.

The level-sustaining hard mask 40 may be made of a single layer made of insulating material (for example, SiO₂ deposited by PECVD) or conductive material (for example, TiN deposited by PVD), or any combination of such layers. In the case where a selective etching process is used to release the nanowires, the material(s) used to make the level-sustaining hard mask 40 should be selected for resistance to the etching chemistry. Selective etching of AAO may use chemistry that partially etches silicon oxide. To overcome this issue, the level-sustaining hard mask 40 may be formed as a composite mask like, for example, SiOx+SiNx or SiOx+TiN.

It is preferable to set the thickness of the level-sustaining hard mask 40 to a low value so as to avoid formation of topological features. Typically, the thickness of the level-sustaining hard mask 40 is on the same order as that of the anodization hard mask (i.e. typically ranging from about 0.5 µm to about 1.5µm).

In preferred embodiments of the invention, the level-sustaining hard mask 40 overlaps a peripheral region of the nanopillar array by a sufficient distance to prevent etching materials used in subsequent process steps from reaching zones of anodic oxide where the pores do not contain nanopillar material. The relevant overlap distance, O, may be determined by experimentation but, for example, in the case where the porous anodic oxide is made of a 5 µm thick layer of AAO, it has been found to be sufficient for a level-sustaining hard mask 40 made of SiO₂ to extend a distance of 20 µm (inward) beyond the boundary of the nanopillar array. In the case of setting the overlap distance O to a value of this kind of magnitude, the level-sustaining hard mask 40 tends to cover the peripheral nanowires that may have morphology that deviates from the desired shape/geometry (notably, peripheral nanowires that are formed at locations where residual metal juts out below the anodic oxide).

Optionally, the height of the anodic oxide matrix 34 and the height of the metal in the pores 36 in the region exposed by the openings 42 in the second hard mask 40 can be trimmed (S305) to planarize the surface and to allow a controlled contact to be obtained. As can be seen from FIG.4E, in the illustrated example method, this removes the overflow metal in the region OR exposed by the opening 42 in the second hard mask 40. In the case where there is overflow metal in a region such as 38o, this may be removed, for example, by etching. It is preferable to perform such etching using dry methods, for example Ion Beam Etching (IBE). The aim is, indeed, not to remove the level-sustaining hard mask 40 but only the overflowed metal 38o. This can be achieved, whilst avoiding an additional lithographic step, by careful choice of the materials used for the level-sustaining hard mask 40 and for the metal forming the nanowires (in view of the selectivity of the etching process) and/or by appropriate setting of the thickness ratios between the overflow region 38o and the level-sustaining hard mask 40. Preliminary evaluation in particular conditions has shown that in the case of using IBE to remove overflowed metal, for a typical required IBE duration of around 30 minutes, a level-sustaining hard mask 40 made of SiO₂ can withstand the process if it is 1 µm thick.

FIG.5 illustrates a simplified example of a top view of the structure represented in FIG.4E. It can be seen that the aperture 42 in the second hard mask 40 is smaller than the aperture 32 in the anodization hard mask 30, so that only a central part of the region containing metal to form the nanowires is exposed from the second hard mask 42. This example is provided for the purpose of illustration only and is not limiting to embodiments. As would be understood by a person of skill in the art based on the teachings herein, the perimeters of the apertures 32 and 42 in the anodization hard mask 30 and second hard mask 40 are not limited to being rectangular and may be of any shape (e.g., circular, oval, etc.). Moreover, if desired there may be a plurality of apertures (two, three, more than three) in the anodization hard mask 30 and/or in the second hard mask 40 so as to form different numbers of porous regions and arrays of released nanowires, respectively.

The nanowires 38 are released (S306) by removing the porous anodic oxide matrix 34 (e.g. by a selective etching process, for instance a wet etching process), to leave a nanowire array structure 50 as illustrated in FIG. 4F. During the selective removal of the anodic oxide from between the nanowires at the centre of the nanowire array (exposed through the aperture 42 in the level-sustaining hard mask 40), the hard mask 40 seals the region around the nanowire array and prevents over-etching of the anodic oxide material surrounding the nanowire array. In the case where the material layer 28 is made of aluminium, and the porous anodic oxide is AAO, it is possible to perform selective etching of AAO on layers such as SiN, Ni and W using process conditions described EP 3656734.

After the selective removal of the anodic oxide material, in a central region R₁ of the nanowire array structure there is a group of released nanowires. Around the periphery of the central region R₁, there is a first region R₂ which comprises anodic oxide matrix material 14 containing (unreleased) metal nanowires 38, and the level-sustaining hard mask 40 overlies this first region R₂. In a second region R₃, located around the periphery of the first region R₂, there is a volume of porous anodic oxide material 34 in which no metal is present, and the level-sustaining hard mask 40 overlies this second region R₃ also. Region R₃ may comprise pores that are misshapen and/or misaligned and certain of these pores may be underlain by a ledge of unanodized metal of the metal layer 28.

The regular nanopillar structure present in region R₁ can be used to embed capacitive structures, or other electronic components.

It can be seen from FIG.4F, and from the SEM image of FIG.6, that the nanowire array structure 50 produced by the method according to the above-described embodiment does not have significant topology at the periphery of the array of free (released) nanowires. Although, at the periphery of the apertures 42 in the level-sustaining hard mask 40, there is a small step between the top surface of the hard mask 40 and the top surface of the free nanowires, the height δH of this step is much smaller than the height difference δL observed in a nanowire array structure produced by the related art method described with reference to Figs.1A to 1D. Thus, it is easier to integrate the nanowire array structure 50 produced according to the method of this embodiment of the invention into a semiconductor product or an integrated circuit.

The level-sustaining hard mask 40 should be in place prior to the releasing of the nanowires. Thus, it should be deposited after the nanowire material is put into the pores. In preferred embodiments of the invention, the level-sustaining hard mask 40 overlies the outer part of the region where the porous anodic oxide contains nanopillar material. In the case where the release of the nanowires is performed by wet etching, over-etching below the level-sustaining hard mask 40 would cause problems comparable to those of the related art if nothing were present underneath it for support. Additional support to the level-sustaining hard mask 40 may be provided by filling the pores 36 to overflowing in step S303 (i.e. forming an overflow region 38o as illustrated in FIG.4C).

It should be understood that methods embodying the present invention, using a level-sustaining hard mask, may be generalized to other configurations. For example, they can be used in cases where the whole of metal layer 28 is to be anodized, i.e., where there is no need to use an anodization hard mask 30 to define selected local regions where porous anodic oxide is to be formed. In such a case, none of the initial metal forming the layer 28 remains after anodization, but only porous structure that is subsequently filled with nanowires. In that case, the level-sustaining hard mask 40 has one or more apertures 42 defining the area(s) where the nanowires should be selectively released (e.g. etched).

Furthermore, the method of FIG.3 may be followed by a step of removing the level-sustaining hard mask 40, after the nanowires have been released. The resulting novel structure 50a is illustrated in FIG.7.

The nanowire array structure 50a of FIG.7 includes an array of free nanowires located within a well having a well sidewall 62, well bottom 64 and well mouth 68. The array of free nanowires 38 is in a region R₁, in the well. Surrounding the array of free nanowires in region R₁, there is a first region R₂ where porous anodic oxide has pores containing nanowires and, surrounding region R₂, a second region R₃ where porous anodic oxide does not contain nanowire material. The surrounding material layer 28 may itself be made of porous anodic oxide or of the material that was anodized to form the porous anodic oxide.

As well as providing methods for fabricating nanowire array structures as described above, the present invention provides nanowire array structures produced by such methods, for example, the nanowire array structure 50 of Fig.4F, and the nanowire array structure 50a of FIG.7 (as well as nanowire array structure 100 described below with reference to FIG.8).

More generally, the level-sustaining hard mask used in embodiments of the invention can be used to planarize substantially any nanopillar structure (nanotubular, nanowire structure) located in a well, notably in cases where this well is delimited by a porous anodic oxide structure, or a porous structure filled with nanowires or any other suitable material (such as, for example, silicon or glass).

Thus, for example, the invention may be implemented in a generic nanopillar array structure such as that illustrated in FIG.8 and labelled 100, wherein a material layer 128 comprises a well 160 and an array of nanopillars 138 is formed in the well 160. The well 160 has a sidewall 162, a well bottom 164 and a well mouth 168 facing the well bottom 164. The nanopillars 138 of the array extend in the direction from the well bottom 164 towards the well mouth 168. To facilitate integration of this nanopillar array structure 100, significant topological features are avoided by virtue of the use of hard mask 140 which is shown overlying the outer peripheral nanopillars of the array. The hard mask 140 extends outwardly relative to the nanopillar array and closes off the well mouth 168 in the region overlying the space between the nanopillar array and the well's sidewall 162. The aperture 142 in the hard mask 140 exposes nanopillars that are located relatively inward of the outermost nanopillars overlain by the hard mask 140. The exposed nanopillars are anchored at their bottom ends but otherwise are unrestricted, whereas the outermost nanopillars overlain by the hard mask 140 may be physically attached to the hard mask and, thus, anchored at both ends.

In the above-described generic case, the level-sustaining hard mask 140 covers the cavity/gap that otherwise would form at the transition between the nanowires and the external material delimiting the well 160.

FIG.9 is a flow diagram illustrating a generic method 900 of fabricating a nanopillar array structure such as that of FIG.8. According to the method of FIG.9, an array of nanopillars is formed (S901) located in a well 160 comprised in a material layer 128, the well 160 having a sidewall 162, a well floor 164 and a well mouth 168 facing the well floor. The nanopillars 138 of the array extend in the direction from the well floor 164 towards the well mouth168. The nanopillars 138 may be formed by any convenient method including, but not limited to, the method mentioned above involving deposition of nanopillar material in pores of a porous anodic oxide, and the method of WO 2008/060665 involving growth of nanotubes by CVD on a patterned catalyst. After the nanopillars have been formed, the level-sustaining hard mask 140 is formed (S902) overlying the outer peripheral nanopillars in the array and extending outwards to cover the remainder of the well mouth. The hard mask 140 is patterned so that the aperture 142 therein exposes the nanopillars disposed inwardly of the outer peripheral nanopillars.

The present invention still further provides semiconductor products which include: a nanopillar array structure embodying the invention, and an electronic component constituted by one or more layers embedded in the array of nanopillars. FIG.10 illustrates an example of one such semiconductor product 200, and relates to an example in which the electronic component is a capacitive structure.

In the example illustrated in Fig.10, towards the left-hand side in the drawing a capacitive structure 260 is provided in which layers forming the dielectric and top electrode of the capacitor are formed over an array 265 of "released" nanowires (i.e. nanowires that are anchored only at their bases). In this example, surrounding the array 265 of released nanowires there is a zone where anodic oxide material is located: this zone has a first region (similar to region R₂ in FIG.4F and in FIG.7) where the pores of the anodic oxide material contain additional nanowires and, surrounding this first region, a second region (similar to region R₃ in FIG.4F and in FIG.7) where the anodic oxide material does not contain nanowires. At the right-hand side of the drawing there is an interconnect structure 280 which provides electrical connection, from the bottom of the structure to the top, using an array 285 of nanowires that are still embedded in porous anodic oxide.

More particularly, in the example illustrated in Fig.10, the nanowire arrays 265 and 285 are connected at their bottom ends to an underlying conductive layer 224, via a barrier layer 226, and a substrate 222 (which may be constituted by an unprocessed wafer or partially-processed wafer) supports the layers 224, 226. The two nanowire arrays 265, 285 are formed in respective wells in a material layer 228 which may, for example, be a layer of anodic oxide or a layer of material that was anodized to form the anodic oxide in the wells. As illustrated an anodization hard mask 230 is present, aligned with the boundaries of the wells, but mask 230 may have been removed prior to formation of level-sustaining hard mask 240. Level-sustaining hard mask 240, and an ancillary hard mask portion 240a, define openings through which contacts 268, 288 connect to the capacitive structure 260 and to the interconnect structure 280, respectively.

A method 1100 of fabricating the semiconductor product 200 of FIG.10 will now be described with reference to FIG.11 and FIGs.12A-12L.

The initial stages of the method 1100 of fabricating the semiconductor product 200 may be implemented similarly to the above-described steps of the method 300 of FIG.3, in order to fabricate an array of released nanowires 265 in a well. Thus, an anodization hard mask 230 is formed (S1101) on a laminated structure comprising a substrate 222, a conductive layer 224 formed on the substrate 222, a barrier layer 226, and a layer 228 of metal for anodization, as can be seen in FIG.12A. Openings 232a and 232b in the anodization hard mask 30 define respective regions where a porous anodic oxide template is to be formed: aperture 232a defines the region/well where the array 265 of released nanowires is to be formed and aperture 232b defines the region/well where the array 285 of nanowires embedded in porous anodic oxide is to be formed. The same materials and process steps may be used to form the structure illustrated in FIG.12A as are used to form the structure illustrated in FIG.4A. However, in the example illustrated in FIGs.12A-12L the substrate 222 is a silicon substrate with thermal oxide layers on both major surfaces. Of course, the substrate is not limited to this structure and may be made of the materials mentioned above in relation to FIG.3 and FIGs.4A-4F, i.e. it could be made of silicon, glass, etc. and may be conducting or insulating.

Using known process steps and process conditions, regions in the metal layer 228 that are exposed from the anodization hard mask 230 are anodized (S1102), producing regions of porous anodic oxide 234 as illustrated in FIG.12B, including pores 236 extending all the way to barrier layer 226 as well as some blocked pores 236b.

The arrays of nanowires are created by providing metal (S1103) into the pores 236 of the porous anodic oxide templates 234, as illustrated in FIG.12C. Once again, this can be achieved, for example, by electrodeposition of a metallic species. In the illustrated example, the metal is deposited so as to overflow the tops of the pores, forming overflow portions 238o, but this is optional.

A level-sustaining hard mask 240 is formed (S1104) over the anodization hard mask 230 (if the anodization hard mask 230 remains) and extends over the outer parts of the regions where the pores 236 contain metal, as shown in FIG.12D. An aperture 242 in the hard mask 240 exposes a selected area of the overflowed metal 238o in the region where the capacitive structure 260 is to be formed. The level-sustaining hard mask 240 helps reduce the size of topological features in the structure and, thus, facilitates deposition of subsequent layers during the fabrication method 900. An ancillary hard mask portion 240a is provided in this specific example, because the capacitive structure to be formed implements a pair of parallel capacitors. The same materials and process steps may be used to form the structure illustrated in FIG.12D as are used to form comparable elements in the structure illustrated in FIG.4D.

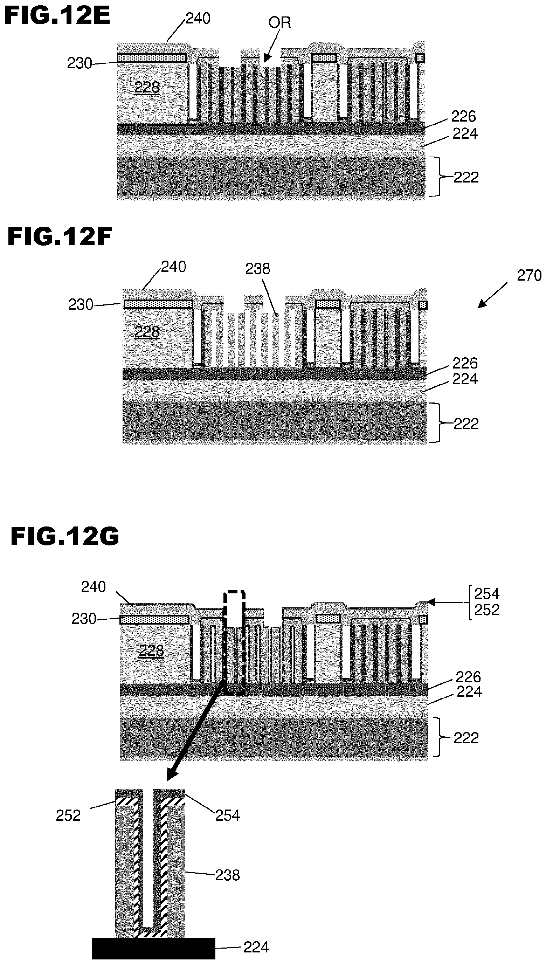

In this example method, in the selected region where the overflowed metal 238o is exposed through the aperture 242 in the level-sustaining hard mask 240, the height of the anodic oxide matrix 234 and the height of the metal in the pores 236 is trimmed (S1105), which removes the overflow metal in the regions OR as illustrated in FIG.12E.

The nanowires 238 to form array 265 are released (S1106) by selectively removing the porous anodic oxide matrix 234, for example, by a selective etching process (for instance, a wet etching process) through the aperture 242 in the mask 240, to leave a nanowire array structure 270 as illustrated in FIG. 12F. During the selective removal of the anodic oxide from between the nanowires in the selected region, the hard mask 40 seals the region around the nanowire array and prevents over-etching of the anodic oxide material surrounding the nanowire array.

An electronic component (here, a capacitive structure) is now formed using the nanowire array 265. More particularly, a layered structure is formed (S1107) on top of the hard mask 240, the layered structure being embedded in-between the nanowires of the array 265 as can be seen in FIG.12G and, especially, in the magnified region at the bottom of that drawing. The deposition of the layered structure may form a so-called metal-insulator-metal (MIM) stack, where the M layers are conductors (for example, metals, metallic compounds, etc.) and the I layer is a dielectric. If space allows, multiple repetitions of the M and I layers may be provided (e.g. MIMIM).

In the present example, the lower electrode of the capacitive structure (first M layer of a simple MIM stack) is constituted by the nanowires 238 themselves. In the present example, a layer 252 of dielectric material is formed over the nanowires 238 to constitute the dielectric of the capacitive structure (I layer of the MIM stack), and a layer 254 of conductive material is formed over the layer 252 so as to constitute the top electrode of the capacitive structure (second M layer of the MIM stack). Preferably, the layers 252 and 254 conform to the shape of the nanowire surface as closely as possible.

In one implementation, one or more conductive layers of the layered structure, which may provide an electrode for the layered structure, may be deposited using an Atomic Layer Deposition (ALD) process with a gaseous halogen-based (e.g., chlorine) precursor. For example, the conductive layer may be made of titanium nitride (TiN). One or more insulator layers of the layered structure, which may provide a dielectric for the layered structure, may be deposited using a process such as CVD or, more preferably, ALD. For example, the insulator layer may correspond to a structure that includes dielectric material (such as an oxide of Si, an oxide of Al, an oxide of Hf or an oxide of Zr) as a single component or as a laminated structure including a plurality of layers, or as a mixture obtained by codeposition. Alternatively, the insulator layer may be formed of a material which, although insulative from the point of view of conduction of electrons, is an ionic conductor (e.g. UPON).

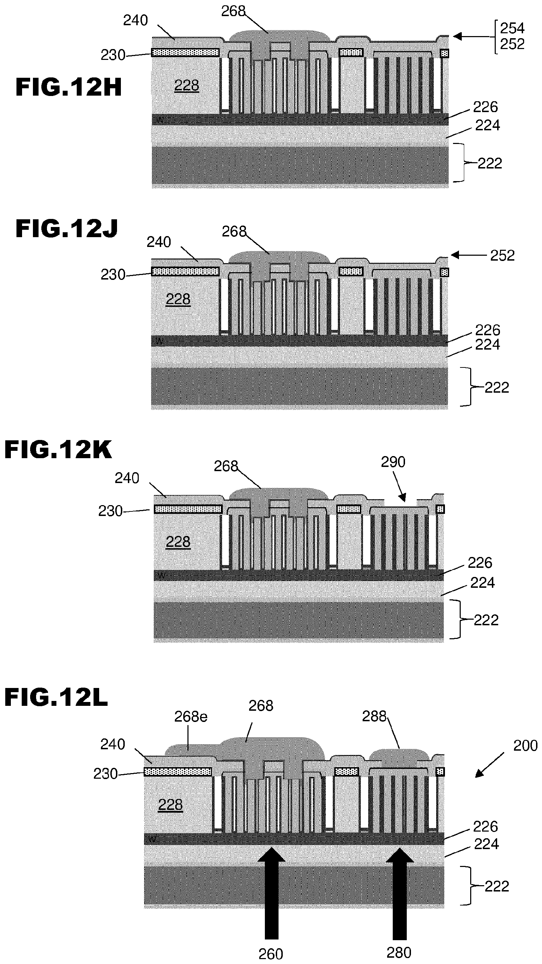

A contact 268 to the top electrode of the capacitive structure 260 is made (S1108), for example by depositing and patterning a metallic layer to produce the structure illustrated in FIG.12H. Then, the remaining portion of conductive layer 254 that is exposed at the top surface of the structure is removed (S1109), for example by a selective etching process, to produce the structure illustrated in FIG.12J. A portion of the hard mask 240 overlying the array 285 of nanowires is removed (S1110) to form an opening 290 as illustrated in FIG.12K. This opening 290 exposes the top of an interconnect structure that is constituted by the nanowires 285 (which provide a current path to the bottom of the nanowire array 260 - and, hence, to the bottom electrode of the capacitive structure 260 - via the barrier layer 226 and conductive layer 224). A contact 288 to the interconnect structure 280 is formed (S1111), for example by deposition and patterning of a metal layer. This step may also produce an extension 268e of the contact 268 to the top electrode of the capacitive structure, to serve as a pad for use in testing, wire-bonding, etc. it is advantageous to have such a pad which does not overlie the porous region. The fabrication process may be simplified by forming the contact 268 and extension 268e in a common deposition step.

In the method 1100 described above, the array of nanopillars 265 in the capacitive structure is formed of conductive wires and these constitute the lower capacitor electrode. However, if desired, or in a case where a capacitive structure is formed over nanopillars that are not (sufficiently) conductive, before formation of the dielectric layer 252 a layer of conductive material can be deposited over the nanopillars to form the lower capacitor electrode.

The method 1100 results in a semiconductor product 200 in which contacts 268, 288 to the top and bottom electrodes of the capacitive structure 260 are both available on the same side of the product (e.g. the top of the product as illustrated in FIG.10 and FIG.12L), exploiting the array 285 of nanowires located in pores of anodic oxide material. However, it should be understood that the methods of fabricating semiconductor products, incorporating capacitive components, according to the invention are not limited to such an approach. Indeed, the contacts to the top and bottom electrodes of the electronic component embedded in the nanopillar array structure may be provided on opposite sides of the semiconductor product. In such a case, the interconnect structure 280 may be omitted.

Furthermore, even in a case where both contacts are provided on the same side of the product, the wiring/connection from the back side to the front side may be implemented by means other than the structure 280 used in the product 200. For example, FIG. 13 is a cross-section through another example of a semiconductor product, 300, according to the present invention. In FIG.13 the reference numerals that designate elements that are comparable to components of the semiconductor product 200 of FIG.10 are indicated using the same reference numerals but beginning with 3 rather than beginning with 2.

In the semiconductor product 300 illustrated in FIG.13, the connection from the back side to the front side is made using remaining unanodized metal of the material layer 328, and a contact plug 388 that passes through the anodization hard mask 330, through the level-sustaining hard mask 340 and through superposed insulation layers 372, 374.

Incidentally, in the semiconductor product 300 illustrated in FIG.13, the capacitive structure is a unitary capacitor (rather than a pair of parallel capacitors), so there is no ancillary hard mask portion such as 240a in product 200. Further, in the semiconductor product 300 illustrated in FIG.13, the lower capacitor electrode (first M layer in the MIM stack) includes a conductive layer 351, and the capacitor dielectric 352 overlies this first conductive layer 351. Moreover, in the semiconductor product 300 illustrated in FIG.13, the conductive layer 324 underlying the barrier layer 326 is a laminated structure consisting of a layer of AlCu sandwiched between two layers of TiTiN, the barrier layer 326 is made of tungsten, the material layer 328 is made of aluminium, the anodization hard mask 330 and level-sustaining hard mask 340 are both made of SiO₂, and the substrate 322 is made of silicon.

FIGs.14A and 14B are SEM images of part of the semiconductor product of FIG.13, namely the part corresponding to the capacitive structure. FIG.14B is a magnified view of a portion of FIG.14A that is indicated by a rectangle. It can be seen from FIGs.14A and 14B that it has been possible to superpose layers over the nanowire array structure and to form connections to elements in the structure.

FIGs.15A and 15B are additional SEM images of example nanowire array structures made by methods according to the present invention. FIG.15A concerns a nanowire array structure made without overflowing metal out of the pores in a porous anodic oxide template, whereas FIG.15B concerns a nanowire array structure made with overflow of metal out of the pores.

In FIG.15A, a level-sustaining hard mask 440 is indicated using dashed lines and an anodization hard mask 430 is indicated using a dot-chain line. Remaining unanodized metal is indicated by 428. The locations of regions R₁, R₂ and R₃ comparable to those discussed above are also marked.

In FIG.15B, a level-sustaining hard mask 540 is indicated using dashed lines and an anodization hard mask 530 is indicated using a dot-chain line. Remaining unanodized metal is indicated by 528. The locations of regions R₁, R₂ and R₃ comparable to those discussed above are also marked.

In both of the cases illustrated in FIGs.15A and 15B it can be seen that the topological features (steps, ledges) at the periphery of the nanowire array are relatively small, making it easier to integrate such array structures into semiconductor products/integrated circuits.

### Additional Variants

Although the present invention has been described above with reference to certain specific embodiments, it will be understood that the invention is not limited by the particularities of the specific embodiments. Numerous variations, modifications and developments may be made in the above-described embodiments within the scope of the appended claims.

## Claims

1. A nanopillar array structure (100), comprising:
a material layer (128) comprising a well (160): the well having a sidewall (162), a well floor (164), and a well mouth (168) facing said well floor;
an array of nanopillars (138) located in said well (160) and extending in the direction from the well floor (164) towards the well mouth (168); and
a hard mask (140) overlying the outer peripheral nanopillars (138p) in said array and extending outwards to cover the remainder of the well mouth (168);
wherein an aperture (142) in said hard mask (140) exposes the nanopillars disposed inwardly of said outer peripheral nanopillars (138p).

2. A nanopillar array structure (50) according to claim 1, comprising porous anodic oxide material (34) at the periphery of the array of nanopillars;
wherein the nanopillars are conductive nanowires (38);
said outer peripheral nanopillars comprise peripheral nanowires (38e) disposed in pores of the porous anodic oxide material (34); and
the hard mask overlies said peripheral nanowires disposed (38e) in the pores of the porous anodic oxide material (34).

3. A nanopillar array structure according to claim 2, wherein:
the porous anodic oxide material (34) at the periphery of the array of nanopillars comprises a first region (R₂) where said peripheral nanowires (38e) are disposed in pores of the porous anodic oxide material (34) and a second region (R₃) where nanowires are not provided in the pores of the porous anodic oxide material, said second region (R₃) being closer than the first region (R₂) to the well sidewall; and
the hard mask (40) overlies said first and second regions (R₂, R₃) of the porous anodic oxide material (34).

4. A nanopillar array structure (50a) according to claim 3, wherein the hard mask (40) is omitted.

5. A nanopillar array structure (50) according to any one of claims 2 to 4, wherein the material layer overlies a conductive layer (24), a surface of the conductive layer defines the well floor, and at least some of said nanopillars disposed inwardly of said outer peripheral nanopillars are in electrical contact with said conductive layer (24) at the well floor.

6. A semiconductor product (200) comprising:
a nanopillar array structure according to any one of claims 1 to 5; and
an electronic component (260) constituted by one or more layers (252-254) embedded in the array of nanopillars.

7. A semiconductor product (200) according to claim 6, wherein said electronic component is a capacitive component (260) constituted by a metal-insulator-metal (MIM) stack embedded in said nanopillar array structure.

8. A semiconductor product (200) according to claim 6 or 7, further comprising an interconnect structure (280) comprising a plurality of nanowires located in respective pores of a region of porous anodic oxide material.

9. A method (900) of fabricating a nanopillar array structure, comprising:
forming (S901) an array of nanopillars located in a well comprised in a material layer, the well having a sidewall, a well floor and a well mouth facing said well floor, the nanowires of said array extending in the direction from the well floor towards the well mouth; and
forming (S902) a hard mask overlying the outer peripheral nanopillars in said array and extending outwards to cover the remainder of the well mouth, wherein an aperture in said hard mask exposes the nanopillars disposed inwardly of said outer peripheral nanopillars.

10. The method (300) of fabricating a nanopillar array structure according to claim 9, wherein:
the forming of the array of nanopillars comprises forming (S303) an array of nanowires in pores of a porous anodic oxide material;
the forming of the hard mask comprises forming (S304) a hard mask overlying the outer peripheral nanowires in said array and extending outwards to cover the remainder of the well mouth, wherein an aperture in said hard mask exposes the nanowires disposed inwardly of said outer peripheral nanowires; and
after the forming of the hard mask, there is provided a step (S306) of releasing said exposed nanowires disposed inwardly of said outer peripheral nanowires, by selectively removing said porous anodic oxide material from between said exposed nanowires, leaving under the hard mask some nanowires located in pores of the porous anodic oxide material.

11. The method of fabricating a nanopillar array structure (50a) according to claim 10, and comprising removing the hard mask (40) after the release of said exposed nanowires.

12. A method of fabricating a semiconductor product (200) comprising:
fabrication (S1101-S1106) of a nanopillar array structure (270) by a method according to any one of claims 9-11; and
embedding (S1107), in the array of nanopillars, one or more layers to form an electronic component.

13. A method of fabricating a semiconductor product (200) according to claim 12, wherein the embedding of one or more layers in the array of nanopillars comprises forming (S1107) a metal-insulator-metal (MIM) stack over the array of nanopillars to form a capacitive component (260).

14. A method of fabricating a semiconductor product (200) according to claim 12 or 13, further comprising forming an interconnect structure (280) comprising a plurality of nanowires located in respective pores of a region of porous anodic oxide material.

15. A method of fabricating a semiconductor product (200) according to claim 14, wherein said array of nanopillars is an array of nanowires, and common process steps (S1101-S1103) form the nanowires of said array of nanopillars and the nanowires of said interconnect structure (280).
